# EUROPEAN PATENT APPLICATION

(11) **EP 2 816 612 A1**
(43) Date of publication of application: **24.12.2014**
(21) Application number: 13749716.0
(22) Date of filing: 30.01.2013
(51) Int. Cl.: H01L 31/05, H01B 1/22, C09J 9/02

(54) **ELECTRICALLY CONDUCTIVE ADHESIVE AGENT, SOLAR CELL MODULE, AND METHOD FOR PRODUCING SOLAR CELL MODULE**

(30) Priority: 14.02.2012 JP 2012029804
(71) Applicant: Dexerials Corporation, Tokyo 141-0032 (JP)
(72) Inventor: MORI, Daichi, Kanuma-shi Tochigi 322-8503 (JP)
(74) Representative: Graf von Stosch, Andreas
(86) International application number: PCT/JP2013/051973
(87) International publication number: WO 2013/121877

(57) **Abstract**

To provide an electrically conductive adhesive, containing: an adhesive resin composition; and aggregates of electrically conductive filaments, wherein the electrically conductive adhesive is configured to connect an electrode of a solar cell with tab wire.

## Description

### Technical Field

The present invention relates to an electrically conductive adhesive configured to connect an electrode formed in a solar cell with tab wire, particularly an electrically conductive adhesive electroconductive filler of which has been improved, and also relates to a solar battery module, in which tab wire is connected using the electrically conductive adhesive, and a method for producing the solar battery module.

### Background Art

In a solar battery module, conventionally, an electrode formed in a solar cell is connected to tab wire, which is to be an interconnector, with soldering. In a crystalline silicon solar battery module, for example, a plurality of solar cells provided adjacent to each other are connected with tab wire formed of a ribbon copper foil, which has been solder coated as an interconnector.

One edge of tab wire is connected to a surface electrode of a solar cell, and the other edge of tab wire is connected to a rear surface electrode of another solar cell provided adjacent to the aforementioned solar cell, to thereby connect the solar cells in series.

Specifically, a bus-bar electrode formed on a light accepting surface of a solar cell with a silver paste by screen printing, and an Ag electrode formed on a rear face connection part of the solar cell were connected with tab wire by soldering (see, for example, PTL 1). In the region outside the connection area on a rear surface of the solar cell, the Al electrode or Ag electrode is formed.

In the soldering, however, the connection treatment is performed at high temperature, i.e., about 260°C. Therefore, there is a concern about reduction in connection reliability between a surface electrode and a rear face electrode of the solar cell and tab wire, due to warping of a solar cell, internal stress caused in a connection part of the tab wire with the surface electrode and the rear face electrode, and residues of flux.

As for a connection between tab wire with a surface electrode and a rear face electrode of a solar cell, therefore, an electrically conductive adhesive film, which can connect by a thermocompression bonding performed at relatively low temperature is conventionally used (see, for example, PTL 2). As for such an electrically conductive adhesive film, used is a film formed by dispersing spherical or flat electrically conductive filler having the average particle diameter of several micrometers in a heat curing binder resin composition, and forming the mixture into a film.

The electrically conductive adhesive film is provided between the surface electrode or rear face electrode and the tab wire. Thereafter, heat and pressure are applied from the top of the tab wire, and as a result, the binder resin exhibits a fluidity to flow out from the space between the electrode and the tab wire, and the electrically conductive filler makes electric connection between the electrode and the tab wire. In this state, the binder resin is cured with heat. As a result of this, a string, in which a plurality of solar cells is connected in series with the tab wire, is formed.

A plurality of solar cells, in which tab wire is connected with surface electrodes and rear face electrodes with the electrically conductive adhesive film, is placed between a translucent surface protecting member, such as glass, and translucent plastic, and a rear face protecting member formed of a film, such as polyethylene terephthalate (PET), and is sealed with a translucent sealing material, such as an ethylene-vinyl acetate copolymer resin (EVA).

In a so-called thin film solar cell, similarly, tab wire is connected with a p-type electrode and an n-type electrode formed on the solar cell with an electrically conductive adhesive film.

The electrode of the solar cell and the tab wire desirably ensure a wide contact area with electrically conductive filler, which makes electrical connection between the electrode and the tab wire, in order to improve conversion efficiency with reducing connection resistance.

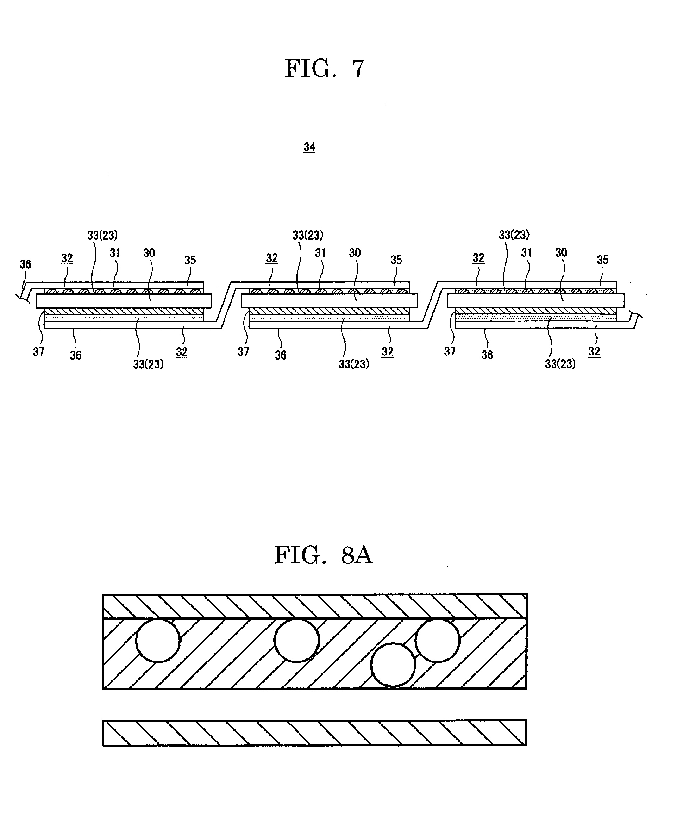

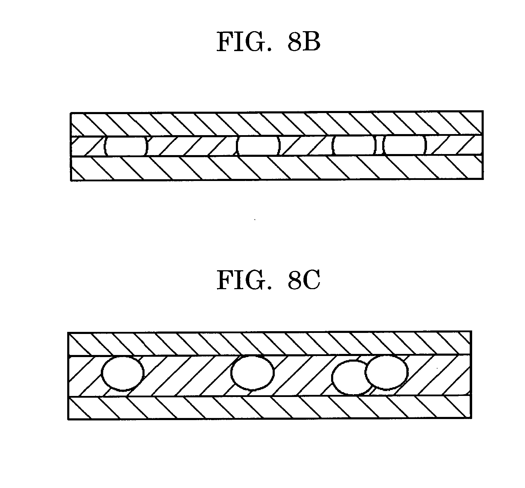

In the case where spherical particles are used as electrically conductive filler as illustrated in FIGs. 8A to 8C, however, the wide contact area cannot be ensured, as contact between the tab wire, the electrode, and the electrically conductive particles sandwiched between them is a point contact. If the electrically conductive particles are strongly pressed to make then flat in order to widen the contact area with the electrically conductive particles, the electrically conductive particles are floated in the adhesive layer due to the residual stress thereof after the connection, which may impair conductivity.

As for the electrically conductive film, there is an anisotropic conductive film (ACF), which is used to realize anisotropic conductive connection, when COF packaging or COG packaging, in which parts, such as a semiconductor, are mounted on a printed circuit or a glass substrate, is performed. This type of the anisotropic conductive film ideally minimizes electric conduction of a transverse direction in order to secure electrical anisotropy. The electrically conductive filler for use is also ideally selected from those having less conduction in a transverse direction.

On the other hand, it is not necessary to consider anisotropic properties for an electrically conductive adhesive film configured to connect an electrode of a solar cell with tab wire. It is rather preferred that the electrically conductive adhesive film have excellent conductivity on the entire connection surface between the electrode and the tab wire.

### Citation List

### Patent Literature

PTL1: Japanese Patent Application Laid-Open (JP-A) No. 2004-356349
PTL2: JP-A No. 2008-135654
PTL3: JP-A No. 2009-38002

### Summary of Invention

### Technical Problem

The present invention aims to solve the aforementioned various problems in the art and to achieve the following object. Specifically, an object of the present invention is to provide an electrically conductive adhesive, which reduces an increase in connection resistance, prevents a reduction in connection reliability, which may be caused by residual stress after connection, and is configured to connect an electrode of a solar cell with tab wire, as well as providing a solar battery module, in which tab wire is connected using the electrically conductive adhesive, and a method for producing the solar battery module.

### Solution to Problem

The means for solving the aforementioned problems are as follows:
<1> An electrically conductive adhesive, containing:
   an adhesive resin composition; and
   aggregates of electrically conductive filaments,
   wherein the electrically conductive adhesive is configured to connect an electrode of a solar cell with tab wire.
<2> The electrically conductive adhesive according to <1>, wherein an amount of the aggregates of the electrically conductive filaments is 5 parts by mass to 40 parts by mass relative to 80 parts by mass of the adhesive resin composition.
<3> The electrically conductive adhesive according to <1> or <2>, wherein diameters of the aggregates of the electrically conductive filaments are in the range of 3 µm to 20 µm.
<4> The electrically conductive adhesive according to any one of <1> to <3>, wherein the electrically conductive adhesive is a film, and the average thickness of the electrically conductive adhesive is 10 µm to 30 µm.
<5> The electrically conductive adhesive according to <4>, wherein a ratio ([the maximum diameter (µm) of the aggregates]/[the average thickness (µm) of the electrically conductive adhesive film]) of the maximum diameter of the aggregates of the electrically conductive filaments to the average thickness of the film-shaped electrically conductive adhesive is 0.2 to 2.0.
<6> The electrically conductive adhesive according to any one of <1> to <5>, further containing spherical or flat electrically conductive particles,
   wherein a mass ratio (the aggregates of the electrically conductive filaments : the electrically conductive particles) of the aggregates of the electrically conductive filaments to the electrically conductive particles is 99:1 to 50:50.
<7> The electrically conductive adhesive according to any one of <1> to <6>, wherein the electrically conductive filaments are nickel filaments.
<8> A solar battery module, containing:
   a solar cell containing an electrode;
   an adhesive layer;
   tab wire connected to the electrode via the adhesive layer;
   a sealing material configured to seal the solar cell; and
   a protective member configured to protect a surface and a rear surface of the solar cell,
   wherein the adhesive layer is formed of the electrically conductive adhesive according to any one of <1> to <7>.
<9> A method for producing a solar battery module, containing:
   arranging tab wire on an electrode of a solar cell via an electrically conductive adhesive; and
   heating and pressing on the tab wire to cure the electrically conductive adhesive to thereby electrically and mechanically connect the tab wire with the electrode,
   wherein the electrically conductive adhesive is the electrically conductive adhesive according to any one of <1> to <7>.

### Advantageous Effects of the Invention

The present invention can solve the aforementioned various problems in the art, achieve the aforementioned object, and provide an electrically conductive adhesive, which reduces an increase in connection resistance, prevents a reduction in connection reliability, which may be caused by residual stress after connection, and is configured to connect an electrode of a solar cell with tab wire, as well as providing a solar battery module, in which tab wire is connected using the electrically conductive adhesive, and a method for producing the solar battery module.

### Brief Description of Drawings

FIG. 1A is a perspective view illustrating one example of a production step of a thin film solar battery module according to the present invention, and depicting bonding to form a laminate.
FIG. 1B is a plan view illustrating one example of a production step of a thin film solar battery module according to the present invention.
FIG. 2 is a perspective view illustrating one example of a thin film solar battery module according to the present invention.
FIG. 3 is a cross-sectional view illustrating one example of a laminate of tab wire and an electrically conductive adhesive film.
FIG. 4 is a plan view illustrating one example of a thin film solar battery module.
FIG. 5A is a cross-sectional view illustrating one example of a heat press step of the electrically conductive adhesive according to the present invention.
FIG. 5B is a cross-sectional view illustrating one example of a heat press step of the electrically conductive adhesive according to the present invention.
FIG. 6 is a perspective view illustrating one example of a silicon solar battery module according to the present invention.
FIG. 7 is a cross-sectional view illustrating one example of a string of silicon solar cells.
FIG. 8A is a cross-sectional view illustrating a heat press step of a conventional electrically conductive adhesive.
FIG. 8B is a cross-sectional view illustrating a heat press step of a conventional electrically conductive adhesive.
FIG. 8C is a cross-sectional view illustrating a heat press step of a conventional electrically conductive adhesive.

### Description of Embodiments

### (Electrically Conductive Adhesive)

The electrically conductive adhesive of the present invention contains at least an adhesive resin composition, and aggregates of electrically conductive filaments, and may further contain other components according to the necessity.

An amount of the aggregates of the electrically conductive filaments in the electrically conductive adhesive is appropriately selected depending on the intended purpose without any limitation, but the amount thereof is preferably 5 parts by mass to 40 parts by mass, more preferably 8 parts by mass to 30 parts by mass, and particularly preferably 15 parts by mass to 25 parts by mass, relative to 80 parts by mass of the adhesive resin composition.

Diameters of the aggregates of the electrically conductive filaments are appropriately selected depending on the intended purpose without any limitation, but the diameters thereof are preferably in the range of 2 µm to 40 µm, more preferably 3 µm to 25 µm, and particularly preferably 3 µm to 20 µm.

The diameters of the aggregates can be measured by means of a metallurgical microscope (e.g., MX series, manufactured by Olympus Corporation).

The electrically conductive adhesive is preferably a film. The average thickness of the film-shaped electrically conductive adhesive is appropriately selected depending on the intended purpose without any limitation, but the average thickness thereof is preferably 10 µm to 30 µm, more preferably 15 µm to 25 µm.

A ratio ([the maximum diameter (µm) of the aggregates]/[the average thickness (µm) of the electrically conductive adhesive film]) of the maximum diameter of the aggregates of the electrically conductive filaments to the average thickness of the film-shaped electrically conductive adhesive is appropriately selected depending on the intended purpose without any limitation, but the ratio thereof is preferably 0.2 to 2.0, more preferably 0.9 to 1.3.

The maximum diameter of the aggregates can be measured by means of a metallurgical microscope (e.g., MX series, manufactured by Olympus Corporation).

The electrically conductive adhesive further contains spherical or flat electrically conductive particles. A mass ratio (the aggregates of the electrically conductive filaments : the electrically conductive particles) of the aggregates of the electrically conductive filaments to the electrically conductive particles is preferably 99:1 to 50:50.

### (Solar Battery Module)

The solar battery module of the present invention contains at least a solar cell containing an electrode, an adhesive layer, tab wire connected to the electrode via the adhesive layer, a sealing material configured to seal the solar cell, and a protecting member configured to protect a surface and rear surface of the solar cell, and may further contain other members according to the necessity.

The adhesive layer is formed of the electrically conductive adhesive of the present invention.

### (Method for Producing Solar Battery Module)

The method for producing a solar battery module according to the present invention contains at least arranging tab wire on an electrode of a solar cell via an electrically conductive adhesive; and heating and pressing on the tab wire to cure the electrically conductive adhesive to thereby electrically and mechanically connect the tab wire with the electrode, and may further contain other steps according to the necessity.

The electrically conductive adhesive is the electrically conductive adhesive of the present invention.

In the present invention, aggregates of electrically conductive filaments are used as electrically conductive filler. The aggregates of the electrically conductive filaments have more contact points with tab wire and electrodes, compared to typical spherical particles or flat particles, and can also conduct in a transverse direction, as the aggregates of the electrically conductive filaments are brought into contact with adjacent aggregates thereof upon application of pressure. Therefore, use of the aggregates of the electrically conductive filaments in the electrically conductive adhesive can keep conduction resistance between tab wire and an electrode low, and can improve a conversion efficiency.

Moreover, the aggregates of the electrically conductive filaments hardly generate residual stress upon application of stress, and give less reduction in the contact areas with the tab wire or electrode caused by floating in the adhesive layer. Therefore, use of the aggregates of the electrically conductive filaments in the electrically conductive adhesive can prevent reduction in connection reliability.

The electrically conductive adhesive of the present invention, the solar battery module using the electrically conductive adhesive, and the method for producing the solar battery module are specifically explained with reference to drawings, hereinafter. Note that, the drawing are schematically illustrated, and a proportion in each size may be different from the actual size. A specific size should be judged based on the following descriptions. Moreover, it is of course true that parts where there are a different relationship in size or different ratio between the drawings are contained.

### [Thin Film Solar Battery Module]

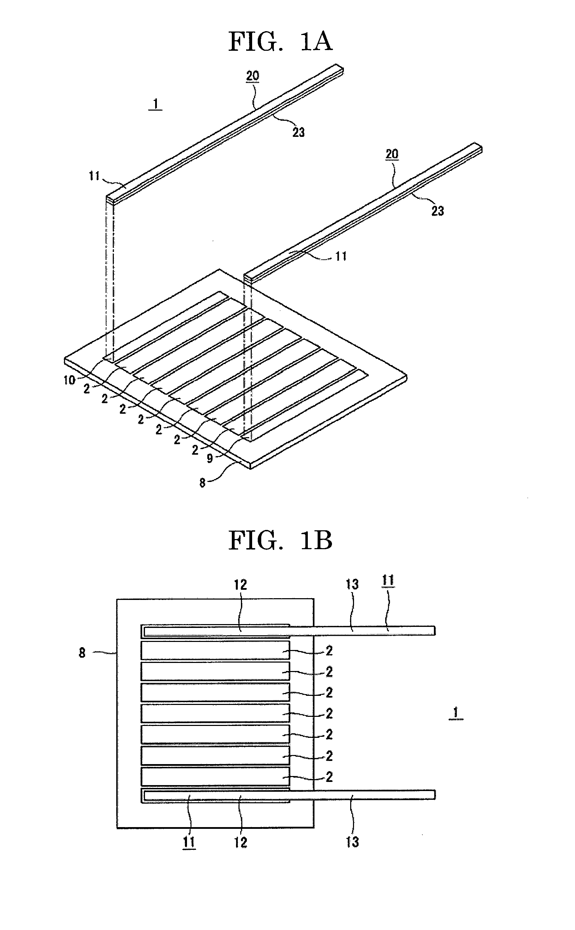

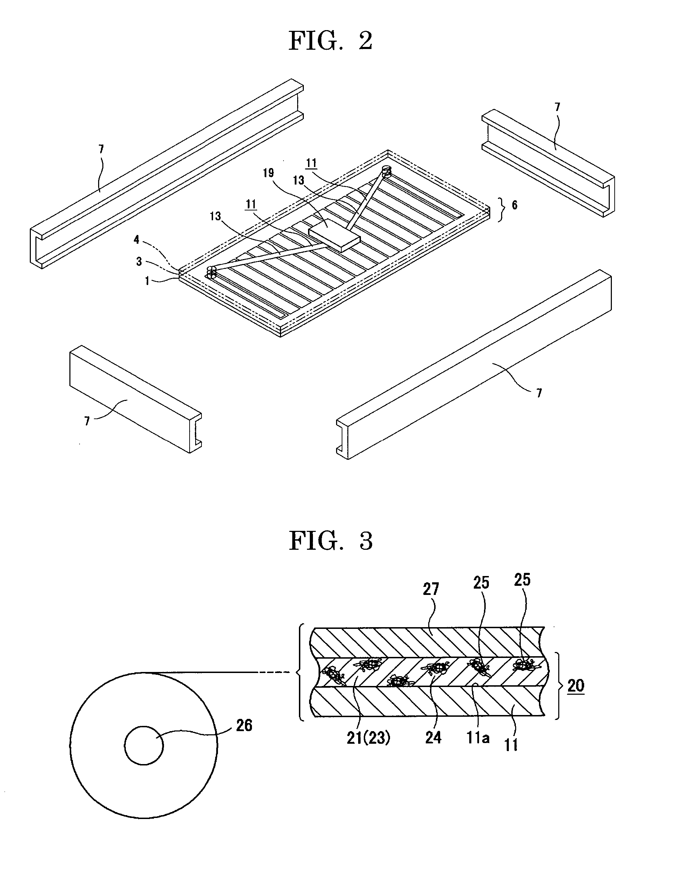

As for a solar cell constituting a solar battery module, for example, a so-called thin film solar cell 1, in which a semiconductor layer serving as a photoelectric conversion layer is formed on a substrate, such as glass, and stainless steel, can be used. As illustrated in FIGs. 1A and 1B, the thin film solar cell 1 constitute a solar cell string, in which a plurality of solar cell elements 2 are connected with a contact line. As illustrated in FIG. 2, a thin film solar cell 1 constituting the string structure alone, or a matrix constituted by linking a plurality thereof are collectively laminated with a sheet 3 of a sealing adhesive, and back sheet 4 provided at the rear face to thereby form a thin film solar battery module 6. Note that, a metal frame 7, such as aluminum, is appropriately provided to the periphery of the thin film solar battery module 6.

As for the sealing adhesive, for example, a translucent sealing material, such as an ethylene vinyl acetate resin (EVA) is provided. As for the back sheet 4, moreover, a plastic film or sheet, which excels in various properties, such as weather resistance, heat resistance, water resistance, and light resistance, can be used. As for the back sheet 4, for example, a laminate sheet having a structure of polyvinyl fluoride (PVF)/polyethylene terephthalate (PET)/polyvinyl fluoride (PVF), which utilizes characteristics of a fluorine-based resin, such as high resistance, can be used.

### [Solar Cell]

The thin film solar cell 1 according to the present invention is formed by laminating a transparent electrode film formed of a transparent electrically conductive film, a photoelectric conversion layer, and a rear face electrode film in this order on the translucent insulating substrate 8, although they are emitted in the drawing. The thin film solar cell 1 is a super straight-type solar cell, to which light enters from the side of the translucent insulating substrate 8. Note that, as for the thin film solar cell, there is also a substraight-type solar cell, in which a base, a rear face electrode, a photoelectric conversion layer, and a transparent electrode are formed in this order. An example of the super straight-type thin film solar cell 1 is explained hereinafter, but the present invention can be also used for a substraight-type thin film solar cell.

Moreover, the solar cell to which the present invention is applied may be, for example, various thin film solar cell, such as amorphous silicon, microcrystal tandem, CdTe, CIS, and a flexible thin film solar cell, or a silicon solar cell, such as a single crystal silicon solar cell, a polysilicon solar cell, and a HIT solar cell.

As for the translucent insulating substrate 8, glass, or a heat resistant resin, such as polyimide, can be used.

As for the transparent electrode film, for example, SnO₂, ZnO, or ITO can be used. As for the photoelectric conversion layer, for example, a silicon-based photoelectric conversion film, such as amorphous silicon, microcrystal silicon, and polycrystal silicon, or a compound-based photoelectric conversion film, such as CdTe, CuInSe₂, and Cu(In,Ga)Se₂ can be used.

The rear face electrode film has, for example, a laminate structure containing a transparent electrically conductive film, and a metal film. As for the transparent electrode film, for example, SnO₂, ZnO, or ITO can be used. As for the metal film, for example, silver, or aluminum can be used.

As illustrated in FIG. 1A, a plurality of solar cell elements 2, each of which has a length equal to substantially the entire width of the translucent insulating substrate 8, and has a rectangular shape, are formed to the thin film solar cell 1 formed in the aforementioned manner. Each solar cell element 2 is separated with an electrode dividing line, and a transparent electrode film of one solar cell element 2 and a rear face electrode film of another adjacent solar cell element 2 are connected with a contact line, to thereby constitute a solar cell string, in which a plurality of the solar cell elements 2 is connected in series.

Then, a linear p-type electrode 9, which has a length substantially equal to the length of the solar cell element 2 is formed on an edge of a transparent electrode film of the solar cell element 2, which is provided at one end of the solar cell strong of the thin film solar cell 1, and a linear n-type electrode 10, which has a length substantially equal to the solar cell element 2, is formed on an edge of a rear face electrode film of the solar cell element 2 provided at the other end. In the thin film solar cell 1, these p-type electrode 9 and n-type electrode 10 function as outlet electrodes, and supply electricity to a terminal box 19 via the tab wire 11.

### [Tab Wire]

The tab wire 11 functions as a terminal to extract electric current, as it is electrically connected to the p-type electrode 9 and the n-type electrode 10. As illustrated in FIG. 3, for example, the adhesive layer (e.g., the electrically conductive adhesive film 23) is laminated on the surface 11a of the the tab wire 11 to form a laminate 20, and the tab wire 11 is used in the form of the laminate 20.

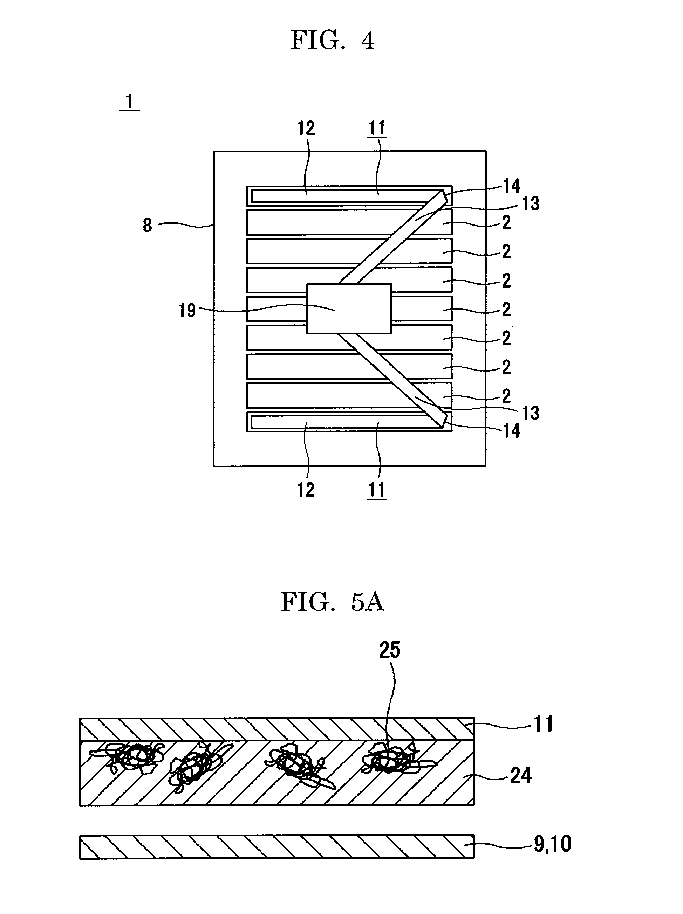

As illustrated in FIG. 4, the tab wire 11 has a power collection tab part 12, which is connected onto a p-type electrode 9 or a-type electrode 10 via an adhesive layer 21, and a connection tab part 13, which is connected to a terminal box 19. The power collection tab part 12 and connection tab part 13 each continue via a turning part 14. Note that, in FIG. 4, a sheet 3 of a sealing adhesive material, and a back sheet 4 are not illustrated, as a matter of practical convenience.

The connection tab part 13 is connected to the terminal box 19 provided on the back sheet 4, with inserted through the sheet 3 of the sealing adhesive material and the back sheet, at the time of the modularization of the thin film solar cell 1.

The tab wire 11 is, for example, a copper foil, which is formed by rolling or electrolysis to give the average thickness of 9 µm to 300 µm. Alternatively, the tab wire 11 is, for example, formed by slitting an aluminum foil. Moreover, the tab wire 11 is formed by rolling a thin metal wire, such as copper, and aluminum, into a plate shape. The tab wire 11 is rectangular wire having a width of 1 mm to 3 mm, which is substantially equal width to those of the p-type electrode 9 and n-type electrode 10.

The power collection tab part 12 has a length that is substantially equal to those of the p-type electrode 9 and n-type electrode 10, and is electrically and mechanically jointed to the entire surface of the p-type electrode 9 or n-type electrode 10 via the adhesive layer 21 laminated on one surface 11a of the tab wire 11. Moreover, the connection tab part 13 is a continuation part of the tab wire 11 partially turned by the turning part 14. At the time of the modularization of the thin film solar cell 1, the edge of the connection tab part 13 is connected to a terminal block of the terminal box 19 provided on the back sheet 4, by inserting the connection tab part 13 into a insertion hole provided in the sheet 3 of the sealing adhesive material and the back sheet, and turning on the back sheet 4.

The turning part 14 is provided at part of the tab wire 11, for example, at the edge of the power collection tab part 12. The part of the tab wire 11, which extends from the turning part 14, becomes the connection tab part 13. The tab wire 11 does not have a joint part, as the power collection tab part 12 and the connection tab part 13 are provided consecutively via the turning part 14. Therefore, increase in resistance or reduction in connection reliability at a joint part due to concentration of electric charge in the joint part, and damage on the translucent insulating substrate formed by concentration of heat or stress in the joint part can be prevented. Note that, as for the tab wire 11, power collection tab for connecting with the p-type electrode 9 and n-type electrode 10, and connection tab for connecting with the terminal box 19 may be jointed using an adhesive, without providing turning parts 14.

The tab wire 11 preferably has a length about twice in the length of the p-type electrode 9 or n-type electrode 10, and is preferably turned at a position, which is about 50% in the entire length thereof. As a result of this, the tab wire 11 enables to securely connect the connection tab part 13 to the terminal box 19 regardless of a position of the terminal box on the back sheet 4 of the thin film solar cell 1.

As illustrated in FIG. 3, an adhesive layer 21 configured to connect the tab wire 11 to the p-type electrode 9 or n-type electrode 10 is provided on the surface 11a of the tab wire 11. The adhesive layer 21 is provided at the entire area of the surface 11a of the tab wire 11, and is composed of an electrically conductive adhesive film 23.

As illustrated in FIG. 3, the electrically conductive adhesive film 23 contains, as electrically conductive filler, aggregates 25 of electrically conductive filaments in a heat curing binder resin layer 24. Moreover, the electrically conductive adhesive film 23 contains the binder resin, the minimum melt viscosity of which is preferably 100 Pa·s to 100,000 Pa·s, in view of compression properties thereof. When the minimum melt viscosity of the electrically conductive adhesive film 23 is lower than 100 Pa·s, the resin may be flown out during curing as low pressure bonding, and therefore connection failures or breading of the resin onto a surface of the cell tends to be caused. When the minimum melt viscosity of the electrically conductive adhesive film 23 is greater than 100,000 Pa·s, a problem tends to be caused when the film is bonded, which may adversely affect connection reliability. Note that, the minimum melt viscosity can be measured by loading the predetermined amount of a sample in a rotational viscometer, and carrying out the measurement with increasing the temperature at the predetermined heating rate.

### [Aggregates of Electrically Conductive Filaments]

As for the aggregates 25 of the electrically conductive filaments, which are sandwiched between the tab wire 11 and the p-type electrode 9 or n-type electrode 10, and functions as electrically conductive filler for electrically connecting the tab wire 11 and the p-type electrode 9 or n-type electrode 10, for example, aggregates of thin and flexible metal wire, such as linear nickel, is used. Since the electrically conductive adhesive film 23 contains the aggregates 25 of the electrically conductive filaments as electrically conductive filler, contact points are increased when the aggregates 25 are sandwiched between the tab wire 11 and the p-type electrode 9 or n-type electrode 10, to thereby reduce connection resistance, and improve a conversion efficiency. As the electrically conductive adhesive film 23 uses the aggregates 25 of the electrically conductive filaments as electrically conductive filler, moreover, residual stress is not generated even when the aggregates 25 are sandwiched between the tab wire 11 and the p-type electrode 9 or n-type electrode 10, and therefore connection reliability can be maintained over a long period.

The aggregates 25 of the electrically conductive filaments are preferably contained in an amount of 5 parts by mass to 40 parts by mass, relative to 80 parts by mass of the binder resin composition (may be also referred as to an "adhesive resin composition"). When the amount of the aggregates 25 of the electrically conductive filaments in the electrically conductive adhesive film 23 is less than 5 parts by mass relative to 80 parts by mass of the binder resin composition, a sufficient number of contact points cannot be provided between the tab wire 11 and the p-type electrode 9 or n-type electrode 10, and therefore conduction resistance may be increased. When the amount of the aggregates 25 of the electrically conductive filaments in the electrically conductive adhesive film 23 is greater than 40 parts by mass relative to 80 parts by mass of the binder resin composition, moreover, the amount of the aggregates of the electrically conductive filaments becomes excessive relative to the amount of the binder resin composition, and therefore adhesion strength becomes low, and connection reliability may be insufficient.

As for the aggregates 25 of the electrically conductive filaments, for example, the aggregates having diameters of 2 µm to 40 µm, in which electrically conductive filaments having diameters of 0.5 µm to 8 µm are aggregated, are preferably used. When the diameters of the electrically conductive filaments are smaller than 0.5 µm or the diameters of the aggregates 25 of the electrically conductive filaments are smaller than 2 µm, a sufficient number of contact points cannot be provided between the tab wire 11 and the p-type electrode 9 or n-type electrode 10, and therefore conduction resistance may be increased. Moreover, use of the electrically conductive filaments having diameters greater than 8 µm or the aggregates 25 of the electrically conductive filaments having diameters greater than 40 µm may increase residual stress upon application of heat and pressure, and reduce dispersibility of the aggregates 25 of the electrically conductive filaments in the binder resin layer 24, and therefore conductivity may be reduced. As the amount thereof increase, moreover, the adhesion strength of the binder resin layer 24 may be lowered.

Moreover, a ratio [the maximum diameter (µm) of the aggregates/the average thickness (µm) of the electrically conductive adhesive film] of the maximum diameter of the aggregates 25 of the electrically conductive filaments to the average thickness of the electrically conductive adhesive film 23, i.e., the average thickness of the binder resin layer 24, is preferably 0.2 to 2.0. When the ratio is less than 0.2, a sufficient number of contact points cannot be provided by the aggregates 25 of the electrically conductive filaments between the tab wire 11 and the p-type electrode 9 or n-type electrode 10, and therefore conduction resistance may be increased. When the ratio is greater than 2.0, moreover, the binder resin layer becomes too thin, and therefore the adhesion force is low and the connection reliability may be insufficient.

In addition to the aggregates 25 of the electrically conductive filaments, the electrically conductive adhesive film 23 may contain spherical electrically conductive particles, or flat electrically conductive particles, as the electrically conductive filler. In this case, the aggregates 25 of the electrically conductive filaments and the electrically conductive particles are preferably contained at the ratio (the aggregates of the electrically conductive filaments : the electrically conductive particles [mass ratio]) of 99:1 to 50:50. When the proportion of the aggregates 25 of the electrically conductive filaments is lower than the aforementioned value in the ratio, a sufficient number of contact points cannot be provided between the tab wire 11 and the p-type electrode 9 or n-type electrode 10, and therefore conduction resistance may be increased, and connection reliability may be lowered by an influence of residual stress caused by the spherical particles.

The spherical or flat electrically conductive particles are not particularly limited, and examples thereof include: metal particles, such as nickel, gold, silver, and copper; gold-plated resin particles; gold-plated resin particles, to which insulating coating is provided as outermost layers; and carbon particles.

Note that, the viscosity of the electrically conductive adhesive film 23 at around room temperature is preferably 10 kPa·s to 10,000 kPa·s, more preferably 10 kPa·s to 5,000 kPa·s. As the viscosity of the electrically conductive adhesive film 23 is in the range of 10 kPa·s to 10,000 kPa·s, so-called blocking caused by spreading can be prevented, when the electrically conductive adhesive film 23 is provided on the surface 11a of the tab wire 11, and wound around a real 26, and moreover a certain degree of tackiness can be maintained.

A composition of the binder resin layer 24 of the electrically conductive adhesive film 23 is not particularly limited, as long as the aforementioned characteristics are not adversely affected. However, the binder resin layer 24 more preferably contains a film forming resin, a liquid epoxy resin, a latent curing agent, and a silane coupling agent, all of which together constitute an adhesive resin composition.

The film forming resin is a high molecular weight resin having the number average molecular weight of 10,000 or greater. In view of film formability, the number average molecular weight of the film forming resin is preferably about 10,000 to about 80,000. As for the film forming resin, for example, various resins, such as an epoxy resin, a modified epoxy resin, a urethane resin, a phenoxy resin, can be used. Among them, a phenoxy resin is suitably used in view of a state of film formation, and connection reliability.

As for the liquid epoxy resin, any of commercial epoxy resins can be used without any limitation, as long as the epoxy resin for use has fluidity at room temperature. Specific examples of the epoxy resin include a naphthalene-based epoxy resin, a biphenyl-based epoxy resin, a phenol novolak-based epoxy resin, a bisphenol-based epoxy resin, a stilbene-based epoxy resin, a triphenol methane-based epoxy resin, a phenol aralkyl-based epoxy resin, a naphthol-based epoxy resin, a dicyclopethadiene-based epoxy resin, and a triphenylmethane-based epoxy resin. These may be used alone, or in combination. Moreover, the epoxy resin may be used in combination with appropriately selected another organic resin, such as an acrylic resin.

As for the latent curing agent, various curing agents, such as a heat curing agent, and a UV curing agent, can be used. The latent curing agent does not initiate a reaction in a normal state, but the latent curing agent is activated by some sort of a trigger to initiate a reaction.

The trigger includes heat, light, and pressure, and can be selected depending on the intended use. Among them, a heat-curing latent curing agent is preferably used in the present embodiment, and the electrically conductive adhesive film is cured as heated and pressed by the p-type electrode 9, and the n-type electrode 10. In the case where the liquid epoxy resin is used, as for the latent curing agent, a latent curing agent composed of imidazole, amine, sulfonium salt, or onium salt can be used.

As for the silane coupling agent, for example, an epoxy-based silane coupling agent, an amino-based silane coupling agent, a mercapto-sulfide based silane coupling agent, or a ureide-based silane coupling agent can be used. Among them, the epoxy-based silane coupling agent is preferably used in the present embodiment. Use of the silane coupling agent can improve adhesion at an interface between an organic material and an inorganic material.

As for other additives, moreover, the electrically conductive adhesive film 23 may contain inorganic filler. Since the electrically conductive adhesive film 23 contains the inorganic filler, the fluidity of the resin layer is controlled at the time of pressure bonding, to thereby improve a particle capturing rate. As for the inorganic filler, for example, silica, talc, titanium oxide, calcium carbonate, or magnesium oxide can be used. A type of the inorganic filler is not particularly limited.

FIG. 3 is a diagram schematically illustrating a laminate 20, in which the tab wire 11 and the electrically conductive adhesive film 23 are laminated. The electrically conductive adhesive film 23 is formed into a tape by laminating the binder resin layer 24 on a release base 27. The tape-shaped electrically conductive adhesive film 23 is wound around a real 26 in the manner that the release base 27 comes at the circumferential side. The release base 27 is not particularly limited, and for example, polyethylene terephthalate (PET), oriented polypropylene (OPP), poly-4-methylpentene-1 (PMP), or polytetrafluoroethylene (PTFE) is used as the release base.

The aforementioned tab wire 11 bonded onto the electrically conductive adhesive film 23 as a cover film. Specifically, the electrically conductive adhesive film 23 is laminated on the surface 11a of the tab wire 11. As the tab wire 11 and the electrically conductive adhesive film 23 are laminated together in advance in the aforementioned manner, temporal bonding of the tab wire 11 with each electrode 9, 10 can be achieved in practical use by releasing the release base 27, and bonding the electrically conductive adhesive film 23 onto the p-type electrode 9 or n-type electrode 10.

The aforementioned electrically conductive adhesive film 23 can be formed using a coating liquid, in which an adhesive resin composition containing the aggregates 25 of the electrically conductive filaments, the film forming resin, the liquid epoxy resin, the latent curing agent, and the silane coupling agent is dissolved in a solvent. As for the solvent, for example, toluene, ethyl acetate, a mixed solvent thereof may be used. The electrically conductive adhesive film 23 is obtained by applying the coating liquid onto the release base 27, and evaporating the solvent. Thereafter, the electrically conductive adhesive film 23 is bonded to the surface 11a of the tab wire 11 by a roller laminator. As a result, a laminate 20, in which the electrically conductive adhesive film 23 is provided on the entire area of the surface 11a of the tab wire 11, is formed.

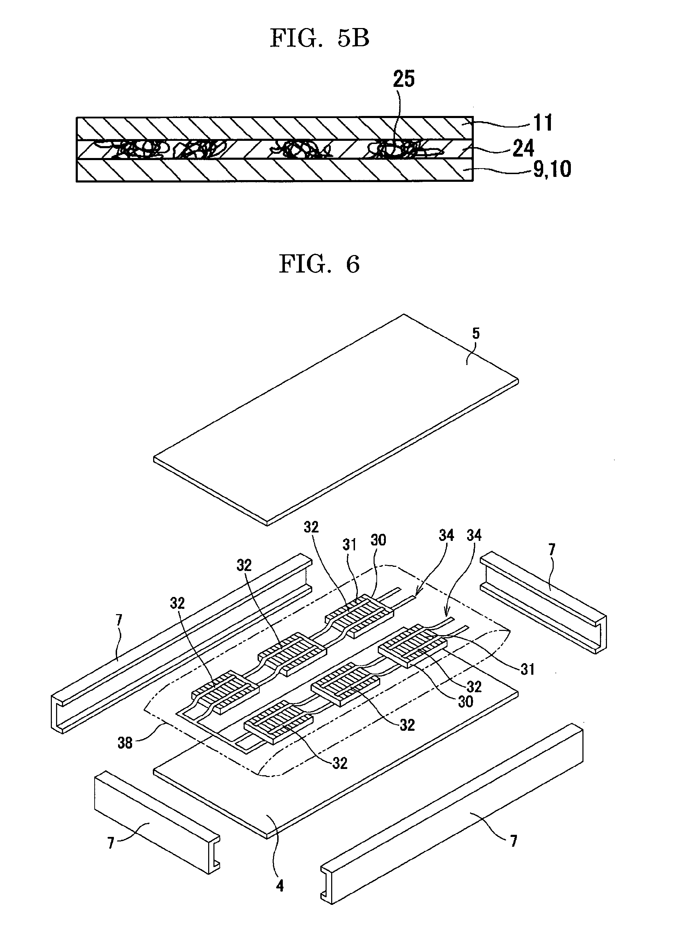

After temporarily bonding the tab wire 11 onto the p-type electrode 9 or n-type electrode 10, the aforementioned electrically conductive adhesive film 23 is heated and compressed by the predetermined temperature and pressure applied by a heat-press head or vacuum laminator. As a result, the binder resin layer 24 of the electrically conductive adhesive film 23 is flown out from the space between the p-type electrode 9 or n-type electrode 10 and the tab wire 11 and the aggregates 25 of the electrically conductive filaments are sandwiched between the tab wire 11 and each electrode 9, 10, as illustrated in FIGs. 5A and 5B. In this state, the binder resin is cured. As a result, the electrically conductive adhesive film 23 can bond the power collection tab part 12 of the tab wire 11 on each electrode 9, 10, as well as electrically connecting the power collection tab part 12 of the tab wire 11 with each electrode 9, 10 via the aggregates 25 of the electrically conductive filaments.

In the electrically conductive adhesive film 23, the aggregates 25 of the electrically conductive filaments are used as electrically conductive filler. Compared to typically spherical particles and flat particles, the aggregates 25 of the electrically conductive filaments gives more contact points with the tab wire 11, and the p-type electrode 9 or n-type electrode 10, and can conduct in a transverse direction as the aggregates 25 of the electrically conductive filaments contact with adjacent aggregates as being pressed. As the electrically conductive adhesive film 23 uses the aggregates 25 of the electrically conductive filaments, the conduction resistance between the tab wire 11 and the p-type electrode 9 or n-type electrode 10 can be maintained low, and conversion efficiency can be improved.

Moreover, the aggregates 25 of the electrically conductive filaments hardly generate residual stress upon application of pressure, and gives less reduction in a contact area with the tab wire 11, and the p-type electrode 9 or n-type electrode 10, which can be caused by floating of the aggregates in the heat cured binder resin layer 24. Therefore, reduction in connection reliability can be prevented by using the aggregates 25 of the electrically conductive filaments in the electrically conductive adhesive film 23.

Furthermore, the aggregates 25 of the electrically conductive filaments have hardly any repulsion against pressure, and therefore the contact area can be increased even when a connection of the tab wire 11 with the p-type electrode 9 or n-type electrode 10 is performed at low pressure. Accordingly, the electrically conductive adhesive film 23 can reduce a load applied to the solar cell. As a solar cell has been particularly recently made thinner, connection of tab wire with low pressure is effective, because a risk, such as warp or crack of a solar cell caused at the time of heating and pressing, can be reduced.

Note that, as for the adhesive layer 21, other than using the laminate 20, in which the tab wire 11 is laminated using the electrically conductive adhesive film 23, the electrically conductive adhesive film 23 is provided on the p-type electrode 9 or n-type electrode 10 of the thin film solar cell as well as the tab wire 11, then, the tab wire 11 may be superimposed on the p-type electrode 9 or n-type electrode 10. Moreover, as for the adhesive layer 21, other than the electrically conductive adhesive film, which is formed by forming the electrically conductive adhesive into a film, an electrically conductive adhesive paste in the form of a paste may be used. The electrically conductive adhesive paste is formed of the same components to those of the electrically conductive adhesive film 23, other than the fact that it is in the form of a paste. In advance to the connection of the tab wire 11, the electrically conductive adhesive in the form of a paste is applied to the p-type electrode 9 or n-type electrode 10, followed by superimposing the tab wire 11.

### [Production Process of Thin Film Solar Battery Module]

Subsequently, a production process of the aforementioned thin film solar battery module 6 is explained. The production process of the thin film solar battery module 6 contains a production step of a thin film solar cell 1, a step containing arranging a laminate 20 of tab wire 11 and an electrically conductive adhesive film 23 on a p-type electrode 9 and n-type electrode terminal 10 of a thin film solar cell 1, and a step containing modularizing the thin film solar cell 1.

The thin film solar cell 1 is produced by a typical method. The thin film solar cell 1 contains a laminate 20 provided on each of the p-type electrode 9 and n-type electrode terminal 10 (FIGs. 1A and 1B). The laminate 20 is pulled out from the real 26 by the predetermined length, and cut, followed by releasing the release base 27. The exposed electrically conductive adhesive film 23 is arranged on the p-type electrode 9 and n-type electrode 10, and is pressed for the predetermined period from the tab wire 11 by a bonder. As a result, the tab wire 11 is temporarily bonded to the p-type electrode 9 and the n-type electrode 10 via the electrically conductive adhesive film 23.

The thin film solar cell 1, to which the tab wire 11 has been temporarily bonded, is moved onto a step of modularization. In the modularization step, modularization is carried out by aligning thin solar cells to form a solar cell string via the tab wire, or modularizing with a single thin film solar cell 1. To the thin film solar cell 1 or the solar cell string, a sheet 3 of a sealing adhesive material and a back sheet 4 are laminated, and these are collectively laminated and sealed by a vacuum laminator. At this process, the connection tab part 13 is inserted into insertion holes provided in the sheet 3 of the sealing adhesive material and the back sheet 4, and is connected to a terminal box 19 provided on the back sheet 4 (FIG. 2).

### [Silicon Solar Cell]

Note that, an example where the thin film solar cell 1 is used as the solar cell is explained above, but the solar cells are connected by connecting the tab wire and electrodes using the electrically conductive adhesive film 23, also when a silicon solar cell is used as the solar cell.

As illustrated in FIGs. 6 and 7, for example, tab wire 32 that cross all finger electrodes 31 is connected to a silicon solar cell 30, in which a plurality of the finger electrodes 31 are provided parallel over the area facing the light receiving surface, via the adhesive layer 33. Similarly to the tab wire 11, the tab wire 32 contains a power collection tab part 35 that is connected to the finger electrodes 31 connected onto the light-receiving surface of the solar cell 30, and a connection tab part 36 that is connected to a rear face electrode 37 of a solar cell 30, which comes next at the time of modularization of a solar cell, or the tab wire 32 provided to the adjacent solar cell 30.

Similarly to the aforementioned adhesive layer 21, the adhesive layer 33 is formed by using an electrically conductive adhesive film 23 formed with the electrically conductive adhesive, or using an electrically conductive adhesive paste. Moreover, the electrically conductive adhesive film 23 may be laminated on the both surfaces of the tab wire 32 in advance, and then tab wire may be bonded to the solar cells 30 at once. Alternatively, the electrically conductive adhesive film 23 may be formed separately from the tab wire 32, and may be individually bonded to the solar cell 30.

The power collection tab part 35 has a length substantially equal to one side of a solar cell 30 crossing the length direction of the finger electrode, and is temporarily bonded onto the light receiving surface via the adhesive layer 33 in a manner that it crosses all the finger electrodes 31. The connection tab part 36 is a part extending from the power collection tab part 35, and is temporarily bonded to a rear face electrode 37 of the adjacent solar cell 30 via the adhesive layer 33.

As a result, the solar cells 30 constitute the string 34, and the string 34 is sandwiched with sheets 3 of a sealing adhesive material, which is collectively laminated with a surface cover 5 provided at the side of the light receiving surface and a back sheet 4 provided at the side of a rear face by means of a vacuum laminator.

At this time, as the tab wire 32 is heated and pressed at the predetermined temperature and pressure by the vacuum laminator, the binder resin of the electrically conductive adhesive film 23 is flown into the space between the finger electrode 31 and the power collection tab part 35, and the space between the rear face electrode 37 and the connection tab part 36, and the aggregates 25 of the electrically conductive filaments are sandwiched between the finger electrode 31 and the power collection tab part 35, and between the rear face electrode 37 and the connection tab part 36. In this state, the binder resin is cured. As a result, the electrically conductive adhesive film 23 bonds the tab wire 32 with the finger electrodes 31 or the rear face electrodes 37, as well as electrically connecting the tab wire 32 with each electrode 31, 37 via the aggregates 25 of the electrically conductive filaments.

As a result, a solar battery module 38, in which a plurality of solar cells 30 is connected, is formed. Note that, a metal frame 7, such as aluminum, is appropriately provided to the periphery of the solar battery module 38.

### [Production Process of Silicon Solar Battery Module]

Subsequently, a production process of the aforementioned silicon solar battery module 38 is explained. Similarly to the production process of the thin film solar battery module, the production process of the silicon solar battery module 38 contains a production step of a silicon solar cell 30, a step containing arranging tab wire 32 on a finger electrode 31 and a rear face electrode 37 of the solar cell 30, and a step modularizing the solar cell 30.

The silicon solar cell 30 is produced by a typical method. After forming finger electrodes 31 and a rear face electrode 37, tab wire 32 is bonded to a light-receiving surface and rear face of the solar cell 30 via an adhesive layer 33, to thereby constitute a string 34. Note that, a bus-barless type solar cell 30, which does not have a bus-bar electrode, is explained hereinafter, but the present invention can be also applied to a solar cell 30 having a bus-bar electrode. In the case where a bus-bar electrode is formed, the tab wire 32 is bonded onto the bus-bar electrode via the adhesive layer 33.

As illustrated in FIG. 6, for example, two lines of tab wire 32 are bonded in a manner that the two lines of the tab wire 32 cross all the finger electrodes 31 formed on the light-receiving surface. Moreover, two lines of tab wire 32 are bonded to the predetermined positions of the rear face electrode 37 formed at the rear face of the solar cell 30.

Thereafter, the solar cell 30 is moved onto a step of modularization. In the modularization step, as illustrated in FIG. 6, sheets 3 of a sealing adhesive material, and a surface cover 5 and a back sheet 4 are laminated on front and rear surfaces of the strings 34, and they are collectively laminated and sealed by a vacuum laminator, to thereby form a silicon solar battery module 38. Note that, a metal frame 7, such as aluminum, is appropriately provided to the periphery of the silicon solar battery module 38.

Note that, other than performing heating and pressing the adhesive layer 33 by collectively laminating and sealing by means of a vacuum laminator, the tab wire 32 and each electrode 31, 37 may be electrically connected by heating and pressing the adhesive layer 33 together with the tab wire 32 in advance to laminate sealing.

### Examples

Examples of the present invention are explained next. In Examples, tab wire was connected to a p-type electrode and n-type electrode of a thin film solar cell, and finger electrodes and a rear face electrode (baked Ag paste) with an electrically conductive film, which used aggregates of nickel filaments as electrically conductive filler, to perform modularization. Thereafter, the resultant was subjected to measurements of connection resistance at an initial stage and after a temperature cycling (TC) test, and the results were evaluated.

The binder resin component (adhesive resin composition) of the electrically conductive adhesive film was composed of 50 parts by mass of a phenoxy resin (YP50, manufactured by NIPPON STEEL & SUMIKIN CHEMICAL CO., LTD.) 4 parts by mass of an epoxy resin (Epicoat 630, manufactured by Mitsubishi Chemical Corporation), 25 parts by mass of a liquid epoxy dispersed imidazole curing agent resin (Novacure 3941HP, manufactured by Asahi Kasei E-materials Corporation), and 1 part by mass of a silane coupling agent (A-187, manufactured by Momentive Performance Materials Inc.).

The binder resin component (adhesive resin composition) and nickel filaments (F255, manufactured by Vale Inco) were mixed, to thereby produce an electrically conductive adhesive film.

In Examples 1 to 4, an amount of the nickel filaments was varied.

### (Example 1)

In Example 1, aggregates were obtained using nickel filaments (F255, manufactured by Vale Inco) having diameters of 2 µm to 3 µm. An amount of the nickel filaments in the electrically conductive adhesive film was set to 5 parts by mass relative to 80 parts by mass of the binder resin component (adhesive resin composition), the average thickness of the binder resin layer (the average thickness of the electrically conductive adhesive film) was 20 µm, and diameters of the aggregates of the filaments in the binder resin layer were 2 µm to 4 µm. A ratio

[the maximum diameter (µm) of the aggregates]/[the average thickness (µm) of the electrically conductive adhesive film] of the maximum diameter of the aggregates of the filaments to the average thickness of the electrically conductive adhesive film was 0.2, and the exposure of the aggregates of the filaments from a surface of the electrically conductive adhesive film was 0% per unit area. Moreover, a pretreatment, such as flux, was unnecessary at the time when the electrically conductive adhesive film was used.

### (Example 2)

In Example 2, an amount of the aggregates of the filaments in the electrically conductive adhesive film was set to 10 parts by mass relative to 80 parts by mass of the binder resin component (adhesive resin composition). The diameters of the aggregates of the filaments in the binder resin layer were 5 µm to 15 µm. Moreover, the ratio [the maximum diameter of the aggregates (µm)]/[the average thickness of the electrically conductive adhesive film (µm)] was 0.8. Other conditions were the same as in Example 1.

### (Example 3)

In Example 3, an amount of the aggregates of the filaments in the electrically conductive adhesive film was set to 20 parts by mass relative to 80 parts by mass of the binder resin component (adhesive resin composition). The diameters of the aggregates of the filaments in the binder resin layer were 5 µm to 20 µm. Moreover, the ratio [the maximum diameter of the aggregates (µm)]/[the average thickness of the electrically conductive adhesive film (µm)] was 1.0, and the exposure of the aggregates of the filaments from a surface of the electrically conductive adhesive film was 5% per unit area. Other conditions were the same as in Example 1.

### (Example 4)

In Example 4, an amount of the aggregates of the filaments in the electrically conductive adhesive film was set to 40 parts by mass relative to 80 parts by mass of the binder resin component (adhesive resin composition). The diameters of the aggregates of the filaments in the binder resin layer were 5 µm to 40 µm. Moreover, the ratio [the maximum diameter of the aggregates (µm)]/[the average thickness of the electrically conductive adhesive film (µm)] was 2.0, and the exposure of the aggregates of the filaments from a surface of the electrically conductive adhesive film was 20% per unit area. Other conditions were the same as in Example 1.

### (Examples 5 and 6)

In Examples 5 and 6, the average thickness (µm) of the electrically conductive adhesive film was changed. Specifically, in Example 5, the average thickness of the binder resin layer was 10 µm, and the amount of the nickel filaments was set to 10 parts by mass in the same manner as in Example 2. The ratio [the maximum diameter of the aggregates (µm)]/[the average thickness of the electrically conductive adhesive film (µm)] was 1.5, and the exposure of the aggregates of the filaments from a surface of the electrically conductive adhesive film was 5% per unit area. Other conditions were the same as in Example 2.

In Example 6, the average thickness of the binder resin layer was 30 µm, and the amount of the nickel filaments was set to 10 parts by mass in the same manner as in Example 2. The ratio [the maximum diameter of the aggregates (µm)]/[the average thickness of the electrically conductive adhesive film (µm)] was 0.5, and the exposure of the aggregates of the filaments from a surface of the electrically conductive adhesive film was 0% per unit area. Other conditions were the same as in Example 2.

### (Examples 7 and 8)

In Examples 7 and 8, in addition to the nickel filaments, spherical nickel particles (SFR-Ni, manufactured by NIPPON ATOMIZED METAL POWDERS CORPORATION) or gold-plated resin particles (Micropearl AU, manufactured by Sekisui Chemical Co., Ltd.) were added as electrically conductive filler to the electrically conductive adhesive film.

Specifically, in Example 7, spherical nickel particles were added to the electrically conductive adhesive film. The particle diameters of the spherical nickel particles were 3 µm, and an amount of the spherical nickel particles added was 2 parts by mass relative to 80 parts by mass of the binder resin component. The amount of the aggregates of the nickel filaments was 8 parts by mass relative to 80 parts by mass of the binder resin component. Other conditions were the same as in Example 2.

In Example 8, gold-plated resin particles were added to the electrically conductive adhesive film. The particle diameters of the gold-plated resin particles were 4 µm, and the amount of the gold-plated resin particles was 2 parts by mass relative to 80 parts by mass of the binder resin component. The amount of the aggregates of the nickel filaments was 8 parts by mass relative to 80 parts by mass of the binder resin component. Other conditions were the same as in Example 2.

### (Examples 9 and 10)

In Examples 9 and 10, the diameters of the nickel filaments were changed.

Specifically, in Example 9, the aggregates were obtained using nickel filaments having diameters of 0.5 µm to 1 µm. The diameters of the aggregates of the filaments in the binder resin layer were 3 µm to 10 µm. The ratio [the maximum diameter of the aggregates (µm)]/[the average thickness of the electrically conductive adhesive film (µm)] was 0.5, and the exposure of the aggregates of the filaments from a surface of the electrically conductive adhesive film was 0% per unit area. Other conditions were the same as in Example 2.

### (Example 10)

In Example 10, the aggregates were obtained using nickel filaments having diameters of 5 µm to 8 µm. The diameters of the aggregates of the filaments in the binder resin layer were 8 µm to 15 µm. The ratio [the maximum diameter of the aggregates (µm)]/[the average thickness of the electrically conductive adhesive film (µm)] was 0.8, and the exposure of the aggregates of the filaments from a surface of the electrically conductive adhesive film was 0% per unit area. Other conditions were the same as in Example 2.

### (Comparative Example 1)

In Comparative Example 1, spherical nickel particles (SFR-Ni, manufactured by NIPPON ATOMIZED METAL POWDERS CORPORATION) were used as electrically conductive filler. The diameters of the spherical nickel particles were 3 µm, and the amount of the spherical nickel particles was 10 parts by mass relative to 80 parts by mass of the binder resin component. The average thickness of the binder resin layer (the electrically conductive adhesive film) was 20 µm, and the diameters of the aggregates of the spherical nickel particles were 3 µm to 10 µm. The ratio [the maximum diameter of the aggregates (µm)]/[the average thickness of the electrically conductive adhesive film (µm)] of the maximum diameter of the aggregates of the spherical nickel particles to the average thickness of the electrically conductive adhesive film was 0.5, and the exposure of the aggregates of the spherical nickel particles from a surface of the electrically conductive adhesive film was 1% per unit area. Moreover, a pretreatment, such as flux, was unnecessary at the time when the electrically conductive adhesive film was used.

### (Comparative Example 2)

In Comparative Example 2, gold-plated resin particles (Micropearl AU, manufactured by Sekisui Chemical Co., Ltd.) were used as electrically conductive filler. The diameters of the gold-plated resin particles were 4 µm, and the amount of the gold-plated resin particles added was 10 parts by mass relative to 80 parts by mass of the binder resin component. The average thickness of the binder resin layer was 20 µm, and the diameters of the aggregates of the gold-plated resin particles in the binder resin layer were 3 µm to 20 µm. The ratio [the maximum diameter of the aggregates (µm)]/[the average thickness of the electrically conductive adhesion film (µm)] of the maximum diameter of the aggregates of the gold-plated resin particles to the average thickness of the electrically conductive adhesive film was 1.0, and the exposure of the aggregates of the spherical nickel particles from a surface of the electrically conductive adhesive film was 3% per unit area. Moreover, a pretreatment, such as flux, was unnecessary at the time when the electrically conductive adhesive film was used.

### (Comparative Example 3)

In Comparative Example 3, tab wire was connected to each electrode of a thin film solar cell and a silicone solar cell using a lead-free solder. At the time of the connection, it was necessary to perform a flux treatment.

The thin film solar cells and silicon solar cells of Examples 1 to 10 and Comparative Examples 1 to 3 were each connected to tab wire in each connection method, and thereafter were each modulated by the aforementioned conventional manner. The resultants were then subjected to the measurement of connection resistance. The measurements were carried out under standard measuring conditions (illuminance: 1,000 W/m², temperature: 25°C, spectrum: AM1.5G) by means of a solar simulator (Solar Simulator PVS1116i-M, manufactured by Nisshinbo Mechatronics Inc.). Moreover, the measurements were carried out in a so-called 4-terminal method, in accordance with JIS C8913 (measuring method of output of a crystal solar cell).

The measurement was performed at the initial stage just after the modularization, and after a temperature cycling (TC) test. The TC test was performed with 100 cycles and 500 cycles, each of which was composed of the temperature of -55°C for 35 minutes and the temperature of 125°C for 35 minutes.

As for the thin film solar cell, the initial connection resistance thereof being less than 50 mΩ was evaluated as A, the initial connection resistance being 50 mΩ or greater but less than 100 mΩ was evaluated as B, and the initial connection resistance being 100 mΩ or greater was evaluated as C.

As for the silicone solar cell, the initial connection resistance thereof being less than 10 mΩ was evaluated as A, the initial connection resistance being 10 mΩ or greater but less than 20 mΩ was evaluated as B, and the initial connection resistance being 20 mΩ or greater was evaluated as C.

As for the evaluation of the connection reliability after the TC test, the connection resistance being less than 1.5 times the initial connection resistance was evaluated as A, 1.5 times or greater but less than 2.0 times was evaluated as B, and 2.0 times or greater was evaluated as C. The results are presented in Tables 1 and 2.

**Table 1**

| | | Ex. 1 | Ex. 2 | Ex. 3 | Ex. 4 | Ex. 5 | Ex. 6 |
|---|---|---|---|---|---|---|---|
| Electrically conductive filler | | Filament aggregates | Filament aggregates | Filament aggregates | Filament aggregates | Filament aggregates | Filament aggregates |
| Amount of electrically conductive filler (mass parts) | | 5 | 10 | 20 | 40 | 10 | 10 |
| Filler diameters (filament diameters) (µm) | | 2 to 3 | 2 to 3 | 2 to 3 | 2 to 3 | 2 to 3 | 2 to 3 |
| Average thickness of electrically conductive adhesive film (µm) | | 20 | 20 | 20 | 20 | 10 | 30 |
| Diameters of filler aggregates in binder resin component (µm) | | 2 to 4 | 5 to 15 | 5 to 20 | 5 to 40 | 5 to 15 | 5 to 15 |
| [Maximum diameter of aggregates (µm)]/[Average thickness of electrically conductive adhesive film (µm)] | | 0.2 | 0.8 | 1.0 | 2.0 | 1.5 | 0.5 |
| Amount of exposed filler per unit area (%) | | 0 | 0 | 5 | 20 | 5 | 0 |
| Necessity of pretreatment | | None | None | None | None | None | None |
| Initial connection resistance (ITO/baked Ag) | | A/A | A/A | A/A | A/A | A/A | A/A |
| Connection reliability (sputter (ITO) electrode) | TC100 | A | A | A | A | A | A |
| | TC500 | B | A | A | B | B | B |
| Connection reliability (baked Ag electrode) | TC100 | A | A | A | A | A | A |
| | TC500 | B | B | A | B | A | B |

**Table 2**

| | | Ex. 7 | Ex. 8 | Ex. 9 | Ex. 10 | Comp. Ex. 1 | Comp. Ex. 2 | Comp. Ex. 3 |
|---|---|---|---|---|---|---|---|---|
| Electrically conductive filler | | Filament aggregates/ spherical nickel | Filament aggregates/ gold-plated resin particles | Filament aggregates | Filament aggregates | Spherical nickel | Gold-plated resin particles | Lead-free solder |
| Amount of electrically conductive filler (mass parts) | | 8/2 | 8/2 | 10 | 10 | 10 | 10 | - |
| Filler diameters (filament diameters) (µm) | | 2 to 3/3 | 2 to 3/4 | 0.5 to 1 | 5 to 8 | 3 | 4 | - |
| Average thickness of electrically conductive adhesive film (µm) | | 20 | 20 | 20 | 20 | 20 | 20 | - |
| Diameters of filler aggregates in binder resin component (µm) | | 5 to 15 | 5 to 15 | 3 to 10 | 8 to 15 | 3 to 10 | 3 to 20 | - |
| [Maximun diameter of aggregates (µm)]/ [Average thickness of electrically conductive adhesive film (µm)] | | 0.8 | 0.8 | 0.5 | 0.8 | 0.5 | 1.0 | - |
| Amount of exposed filler per unit area (%) | | 0 | 0 | 0 | 0 | 1 | 3 | - |
| Necessity of pretreatment | | None | None | None | None | None | None | Yes (Flux) |
| Initial connection resistance (ITO/baked Ag) | | A/A | A/A | A/B | A/A | A/A | A/A | C/A |
| Connection reliability (sputter (ITO) electrode) | TC100 | A | A | A | A | B | A | C |
| | TC500 | B | A | B | B | C | B | C |
| Connection reliability (baked Ag electrode) | TC100 | A | A | B | A | B | A | A |
| | TC500 | B | B | B | B | C | C | B |

In Tables 1 and 2, "electrically conductive filler amount" is an amount (parts by mass) relative to 80 parts by mass of the binder resin component (adhesive resin composition).

As depicted in Tables 1 and 2, both the thin film solar cells and silicon solar cells of Examples 1 to 10, where the aggregates of the nickel filaments were used as electrically conductive filler, were evaluated as A or B in the initial connection resistance, and had an increase of the connection resistance after the TC test, which was less than 2 times compared to the initial value.

This is because a contact area between the tab wire and the electrode is increased by using the aggregates of the nickel filaments as electrically conductive filler to thereby reduce connection resistance, and reduction in the connection reliability due to residual stress does not occur.

On the other hand, both the thin film solar cell and silicon solar cell of Comparative Example 1 where spherical nickel particles were used as electrically conductive filler increased the connection resistance by 2 times or greater compared to the initial value after 500 cycles of the TC test. Moreover, the silicon battery cell of Comparative Example 2 where gold-plated resin particles were used as electrically conductive filler increased the connection resistance by 2 times or greater compared to the initial value after 500 cycles of the TC test. This is probably because the contact area between the tab wire and the electrode was reduced after the TC test due to the residual stress of the electrically conductive filler.

Note that, in Comparative Example 3 where lead-free solder was used, the connection of the electrode (ITO film) of the thin film solar cell increased the resistance both at the initial stage and after the TC test. When the silicon solar battery was used, moreover, a flux treatment was necessary to thereby complicate the process.

Looking at the results of Examples 1 to 4, the connection resistance was slightly increased after the 500 cycles of the TC test in Examples 1 and 4. This is because the amount of the nickel filaments in Example 1 is small compared to other Examples. In Example 4, moreover, it is considered that adhesion strength is relatively decreased, as the amount of the nickel filaments is large relative to the binder resin layer, compared to other Examples.

Looking at the results of Examples 5 and 6, the connection resistance of the thin film solar cell was increased after the 500 cycles of the TC test in Example 5. This is because the average thickness of the binder resin layer is slightly thin, and the adhesion strength is relatively decreased. In Example 6, moreover, the connection resistance of both solar cells increased after the 500 cycles of the TC test. This is because the average thickness of the binder resin is slightly thick, and therefore the contact area with the aggregates of the electrically conductive filaments is decreased.

Looking at the results of Examples 7 and 8, there the nickel filaments and the spherical particles could be used without any significant problems in both the connection resistance and connection reliability, when the blending ratio (mass ratio) of the nickel filaments to the spherical particles was made 8:2.

Looking at the results of Examples 9 and 10, the diameters of the nickel filaments and the diameters of the aggregates of the filaments were slightly small in Example 9, and thus the initial connection resistance of the silicon solar cell and connection resistance thereof after the TC test slightly increased.

### Reference Signs List

- 1: thin film solar cell
- 2: solar cell
- 3: sheet
- 4: back sheet
- 5: surface cover
- 6: thin film solar battery module
- 7: metal frame
- 8: translucent insulating substrate
- 9: p-type electrode
- 10: n-type electrode
- 11: tab wire
- 12: power collection tab part
- 13: connection tab part
- 14: turning part
- 19: terminal box
- 20: laminate
- 21: adhesive layer
- 23: electrically conductive adhesive film
- 24: binder resin layer
- 25: aggregates of electrically conductive filaments
- 26: reel
- 27: release base
- 30: solar cell
- 31: finger electrode
- 32: tab wire
- 33: adhesive layer
- 34: string
- 35: power collection tab part
- 36: connection tab part
- 37: rear face electrode
- 38: silicon solar battery module

## Claims

1. An electrically conductive adhesive, comprising:
an adhesive resin composition; and
aggregates of electrically conductive filaments,
wherein the electrically conductive adhesive is configured to connect an electrode of a solar cell with tab wire.

2. The electrically conductive adhesive according to claim 1, wherein an amount of the aggregates of the electrically conductive filaments is 5 parts by mass to 40 parts by mass relative to 80 parts by mass of the adhesive resin composition.

3. The electrically conductive adhesive according to claim 1 or 2, wherein diameters of the aggregates of the electrically conductive filaments are in the range of 3 µm to 20 µm.

4. The electrically conductive adhesive according to any one of claims 1 to 3, wherein the electrically conductive adhesive is a film, and the average thickness of the electrically conductive adhesive is 10 µm to 30 µm.

5. The electrically conductive adhesive according to claim 4, wherein a ratio ([the maximum diameter (µm) of the aggregates]/[the average thickness (µm) of the electrically conductive adhesive film]) of the maximum diameter of the aggregates of the electrically conductive filaments to the average thickness of the film-shaped electrically conductive adhesive is 0.2 to 2.0.

6. The electrically conductive adhesive according to any one of claims 1 to 5, further comprising spherical or flat electrically conductive particles,
wherein a mass ratio (the aggregates of the electrically conductive filaments : the electrically conductive particles) of the aggregates of the electrically conductive filaments to the electrically conductive particles is 99:1 to 50:50.

7. The electrically conductive adhesive according to any one of claims 1 to 6, wherein the electrically conductive filaments are nickel filaments.

8. A solar battery module, comprising:
a solar cell containing an electrode;
an adhesive layer;
tab wire connected to the electrode via the adhesive layer;
a sealing material configured to seal the solar cell; and
a protective member configured to protect a surface and a rear surface of the solar cell,
wherein the adhesive layer is formed of the electrically conductive adhesive according to any one of claims 1 to 7.

9. A method for producing a solar battery module, comprising:
arranging tab wire on an electrode of a solar cell via an electrically conductive adhesive; and
heating and pressing on the tab wire to cure the electrically conductive adhesive to thereby electrically and mechanically connect the tab wire with the electrode,
wherein the electrically conductive adhesive is the electrically conductive adhesive according to any one of claims 1 to 7.
